# EUROPÄISCHE PATENTSCHRIFT

(11) **EP 0 583 250 B1**
(45) Veröffentlichungstag und Bekanntmachung des Hinweises auf die Patenterteilung: **07.12.1994**
(21) Anmeldenummer: 92907035.7
(22) Anmeldetag: 23.03.1992
(51) Int. Cl.: G01N 27/06, G01R 27/22

(54) **INTEGRIERBARE LEITFÄHIGKEITSMESSVORRICHTUNG**
INTEGRATABLE CONDUCTIVITY MEASURING DEVICE
DISPOSITIF INTEGRABLE DE MESURE DE LA CONDUCTIVITE

(30) Priorität: 20.04.1991 DE 4113033
(43) Veröffentlichungstag der Anmeldung: 23.02.1994
(73) Patentinhaber: FRAUNHOFER-GESELLSCHAFT ZUR FÖRDERUNG DER ANGEWANDTEN FORSCHUNG E.V., 80636 München (DE)
(72) Erfinder: KORDAS, Norbert, D-4300 Essen 1 (DE)
(74) Vertreter: Schoppe, Fritz, Dipl.-Ing.
(86) Internationale Anmeldenummer: DE9200242
(87) Internationale Veröffentlichungsnummer: WO9218856

(56) Entgegenhaltungen:
- US-A- 3 495 164
- US-A- 3 757 205
- US-A- 4 656 427
- US-A- 4 833 413

## Beschreibung

Die vorliegende Erfindung betrifft eine integrierbare Leitfähigkeitsmeßvorrichtung zur Messung der elektrischen Leitfähigkeit von Flüssigkeiten mit einer Stromquellenvorrichtung, die an zwei Stromelektroden derart angeschlossen ist, daß über die Stromelektroden ein Strom mit einem rechteckförmigen Verlauf in die Flüssigkeit einspeisbar ist, und mit einer an zwei Spannungselektroden angeschlossenen Meßschaltung zum Bestimmen des Spannungsabfalles zwischen den beiden Spannungselektroden, welcher von der elektrischen Leitfähigkeit der untersuchten Flüssigkeit abhängt, gemäß dem Oberbegriff des Patentanspruchs 1.

Es ist allgemein bekannt, zum Zwecke der Bestimmung der elektrischen Leitfähigkeit einer Flüssigkeit in diese einen Strom einzuprägen und den Spannungsabfall innerhalb der Flüssigeit, welcher umgekehrt proportional zur Leitfähigkeit der Flüssigkeit ist, zu messen.

Im einfachsten Fall werden hierzu lediglich zwei Elektroden benutzt. Über diese zwei Elektroden wird der Strom in die Flüssigkeit eingeprägt und gleichzeitig der Spannungsabfall über dieselben Elektroden gemessen. Hierbei treten sogenannte Polarisationseffekte auf, die das eigentliche Meßsignal verfälschen. Diese Effekte treten immer dann auf, wenn ein Strom über eine Grenzschicht zwischen einer Elektrode und einem Elektrolyt fließt. Da in einem Elektrolyten ein Stromfluß mit der Wanderung von Ionen verbunden ist, bilden sich an der Grenzschicht zwischen dem Elektrolyten und der Elektrode Ansammlungen von Ionen eines Ladungstypes, die das ursprüngliche Feld schwächen und das Meßsignal vermindern.

Um diesen Nachteil zu vermeiden, werden Leitfähigkeitsmeßvorrichtungen mit sogenannten Vier-Elektroden-Anordnungen verwendet, bei denen eine Stromquelle mit zwei Stromelektroden zur Einprägung eines Meßstromes vorgesehen ist. Zwei weitere Elektroden, die als Spannungselektroden bezeichnet werden können, dienen zur Messung der über die Flüssigkeit abfallenden Spannung. Der Spannungsabfall, der durch die Spannungselektroden abgegriffen wird, wird durch einen den Spannungselektroden nachgeschalteten hochohmigen Verstärker verstärkt. Aufgrund der hohen Eingangsimpedanz der Verstärker kann der über die Spannungselektroden fließende Strom gering gehalten werden, so daß bei dieser Meßmethode die Polarisationseffekte reduziert werden, woraus sich eine verbesserte Meßgenauigkeit gegenüber der Leitfähigkeitsmessung mit lediglich zwei Elektroden ergibt. Jedoch führt auch bei der Vier-Elektroden-Anordnung der über die Spannungselektroden fließende Meßstrom zu einer Polarisation und somit zu einer Verfälschung des Meßsignales.

Aus der US 4,656,427 ist bereits eine Leitfähigkeitsmeßvorrichtung der eingangs genannten Art bekannt, welche mit der Vier-Elektroden-Anordnung arbeitet. Zwei Stromelektroden sind mit einem rechteckförmigen Strom beaufschlagbar. Zwei Spannungselektroden, denen Kondensatoren zur Abtrennung von Gleichpotentialen nachgeschaltet sind, dienen zur Erfassung der dynamischen Potentialänderung aufgrund des in die zu messende Flüssigkeit eingeprägten rechteckförmigen Wechselstromes. Dieses Signal wird durch eine nachfolgende Auswertungsschaltung, die über einen zusätzlichen, in Reihe geschalteten Kondensator zur Abtrennung von Offset-Strömen verfügt, verstärkt und nach Analog-Digital-Wandlung auf einer Anzeigeeinheit dargestellt.

Gleichfalls ist es bekannt, bei Leitfähigkeitsmeßvorrichtungen der soeben geschilderten Art den eingeprägten Strom als sinusförmigen Wechselstrom zu erzeugen, um durch diese Maßnahme Zersetzungsvorgänge in der Flüssigkeit zu vermeiden, die im Falle einer Messung mit eingeprägtem Gleichstrom auftreten würden.

Ausgehend von dem oben geschilderten Stand der Technik liegt der vorliegenden Erfindung die Aufgabe zugrunde, eine Leitfähigkeitsmeßvorrichtung der eingangs genannten Art so weiterzubilden, daß eine erhöhte Meßgenauigkeit erzielt wird.

Diese Aufgabe wird erfindungsgemäß durch eine integrierbare Leitfähigkeitsmeßvorrichtung gemäß Patentanspruch 1 gelöst.

Der Erfindung liegt die Erkenntnis zugrunde, daß durch Verwendung einer Stromquellenvorrichtung, die einen rechteckförmigen Strom erzeugt, in Kombination mit einer als Schalter-Kondensator-Schaltung ausgeführten Meßschaltung Meßfehler aufgrund von Polarisationseffekten vollständig vermieden werden können.

Die erfindungsgemäße Leitfähigkeitsmeßvorrichtung kann als integrierte Schaltung ausgeführt werden, so daß sie einschließlich der Elektroden auf einem einzigen Substrat implementiert werden kann. Hierdurch kann die erfindungsgemäße Leitfähigkeitsmeßvorrichtung für die Messung innerhalb sehr kleiner Probenvolumina oder für die Messung an Stellen, die für Leitfähigkeitsmeßvorrichtungen nach dem Stand der Technik unzugänglich sind, wie beispielsweise im Bereich der invasiven medizinischen Diagnostik, eingesetzt werden.

Durch die Integrierbarkeit der erfindungsgemäßen Leitfähigkeitsmeßvorrichtung ist diese weniger anfällig gegenüber eingestrahlten Störungen als Leitfähigkeitsmeßvorrichtungen nach dem Stand der Technik, bei denen regelmäßig längere Kabelverbindungen zwischen den Elektroden und der Auswertungselektronik verwendet werden. Daher eignet sich die erfindungsgemäße Leitfähigkeitsmeßvorrichtung auch für den Einsatz unter Umgebungsbedingungen mit starken elektromagnetischen Störfeldern.

Nachfolgend wird die erfindungsgemäße integrierbare Leitfähigkeitsmeßvorrichtung unter Bezugnahme auf die beiliegenden Zeichnungen näher erläutert.

Es zeigen:
- Fig. 1: ein Schaltbild der erfindungsgemäßen Leitfähigkeitsmeßvorrichtung; und
- Fig. 2: ein Zeitdiagramm von Strömen bzw. Spannungen, wie sie in der Leitfähigkeitsmeßvorrichtung gemäß Fig. 1 auftreten.

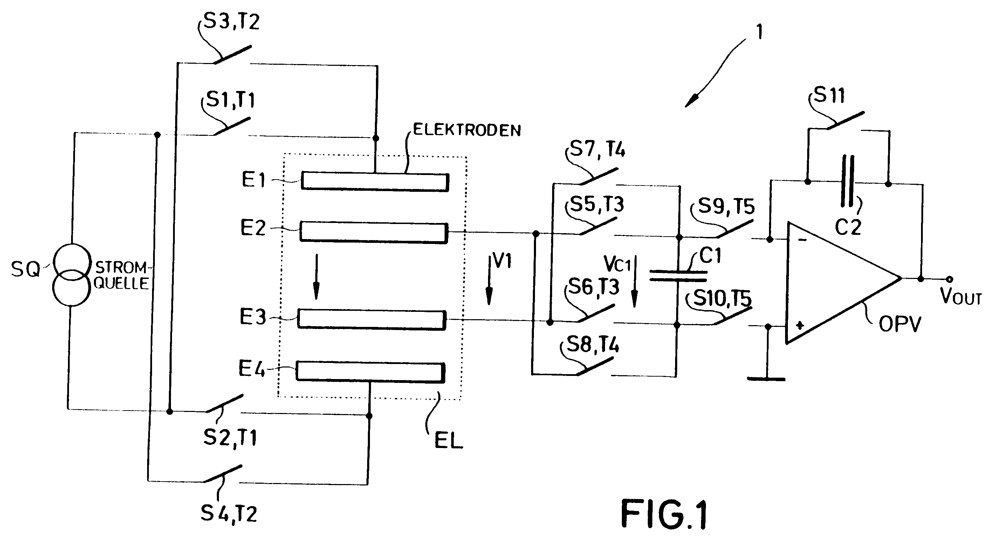

Das in Fig. 1 gezeigte bevorzugte Ausführungsbeispiel der erfindungsgemäßen integrierbaren Leitfähigkeitsmeßvorrichtung, die in ihrer Gesamtheit mit dem Bezugszeichen 1 bezeichnet ist, umfaßt eine Stromquelle SQ zur Erzeugung eines eingeprägten Gleichstromes, welche über einen ersten bis vierten Schalter S1, S2, S3, S4 in Abhängigkeit von deren Schaltzustand in einer ersten Polung oder in einer zu der ersten Polung entgegengesetzten Polung mit zwei Stromelektroden E1, E4 verbindbar ist.

Die Stromelektroden erzeugen in einem Elektrolyt EL einen rechteckförmigen Strom ohne Gleichanteil.

Eine (nicht gezeigte) Steuervorrichtung steuert den ersten bis vierten Schalter S1 bis S4 derart an, daß die Stromquelle SQ alternierend während einer ersten Zeitdauer T1 in der ersten Polung und während einer zweiten Zeitdauer T2 in der zweiten Polung mit den Stromelektroden E1, E4 verbunden wird. Die erste und zweite Zeitdauer T1, T2 sind gleich lang.

Zwischen den Stromelektroden E1, E4 sind zwei Spannungselektroden E2, E3 in dem Elektrolyten EL angeordnet, die den durch den eingeprägten rechteckförmigen Strom zwischen den Stromelektroden E1, E4 über den Elektrolyten auftretenden Spannungsabfall V1 messen.

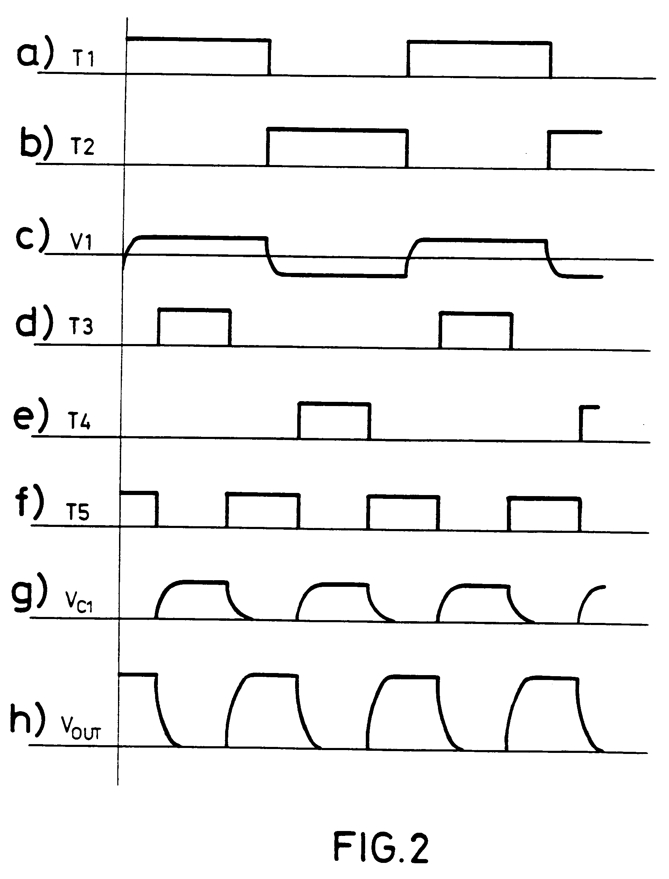

Der zeitliche Verlauf des Spannungsabfalls V1 bezogen auf die erste und zweite Zeitdauer T1, T2 ist in den Fig. 2a bis 2c gezeigt.

Die Spannungselektroden E2, E3 sind über einen fünften bis achten Schalter S5, S6, S7, S8 in einer ersten bzw. zweiten Polung mit den Elektroden eines Meßkondensators C1 verbindbar.

Der fünfte, sechste, siebte und achte Schalter S5 bis S8 werden gleichfalls von der (nicht dargestellten) Steuervorrichtung, die als Mikroprozessor ausgestaltet sein kann, angesteuert. Die Ansteuerung erfolgt derart, daß die Spannungselektroden E2, E3 während einer dritten Zeitdauer T3 in der ersten Polung und während einer vierten Zeitdauer T4 in einer zweiten Polung mit dem Meßkondensator C1 verbunden werden. Wie aus den Fig. 2d, 2e in Hinblick auf die Fig. 2a, 2b ersichtlich ist, liegen die dritte Zeitdauer T3 innerhalb der ersten Zeitdauer T1 und die vierte Zeitdauer T4 innerhalb der zweiten Zeitdauer T2.

Ein neunter und zehnter Schalter S9, S10 liegen zwischen den beiden Elektroden des Meßkondensators C1 und dem invertierenden bzw. nicht-invertierenden Eingang eines Operationsverstärkers OPV, dessen Ausgang über einen Rückkopplungskondensator C2 mit dessen invertierenden Eingang in Verbindung steht.

Die Steuervorrichtung (nicht dargestellt) verbindet jeweils während einer fünften Zeitdauer, die außerhalb der dritten und vierten Zeitdauer T3, T4 liegt, den Meßkondensator C1 mit den Eingängen des Operationsverstärkers OPV. Entsprechend des Kapazitätsverhältnisses des Rückkopplungskondensators C2 und Meßkondensators C1 wird hierdurch die Spannung am Meßkondensator V_{C1} zu einer am Ausgang des Operationsverstärkers erzeugten Spannung V_{OUT} verstärkt.

Bei dem gezeigten Ausführungsbeispiel schließt die (nicht dargestellte) Steuervorrichtung jeweils nach Ablauf der fünften Zeitdauer einen parallel zu dem Rückkopplungskondensator C2 geschalteten elften Schalter S11, so daß die gezeigte Schalter-Kondensator-Schaltung S5 bis S11, C1, C2, OPV als Verstärkerschaltung arbeitet. Es ist jedoch auch möglich, den elften Schalter S11 jeweils nach mehreren Perioden T1, T2 zu schließen, so daß die Schalter-Kondensator-Schaltung in diesem Fall als Integrationsschaltung arbeitet.

Wie sich aus der Betrachtung des Verlaufs des Spannungsabfalls über die Spannungselektroden E2, E3 gemäß Fig. 2c ergibt, sind die erste und zweite Zeitdauer jeweils ausreichend lang gewählt, daß Umschalteffekte abklingen und die Spannung V1 einen im wesentlichen konstanten Wert annimmt. Erst nach Abklingen der Umschaltvorgänge wird während der Zeitdauer T3 der Meßkondensator mit den Spannungselektroden verbunden. Hierdurch fließen Ladungsträger über die Spannungselektroden E2, E3 auf die Elektroden des Meßkondensators C1. Zu Beginn der Zeitdauer T3 führt dieser Stromfluß zu einer Störung des ursprünglichen Feldes zwischen den Stromelektroden E1, E4 und zu einer vorrübergehenden Polarisation. Mit zunehmender Aufladung des Meßkondensators C1 strebt der Meßstrom an den Spannungselektroden E2, E3 exponentiell gegen Null, so daß die Spannungselektroden E2, E3 bei einer hinreichenden Länge der dritten Zeitdauer T3 stromlos werden. Bei einer vom Einzelfall abhängigen, experimentell jedoch leicht bestimmbaren hinreichenden dritten Zeitdauer T3 haben Polarisationseffekte keinen negativen Einfluß mehr auf die erzielbare Meßgenauigkeit.

Die erfindungsgemäße Leitfähigkeitsmeßschaltung eignet sich für eine Integration der Elektroden E1 bis E4, der Stromquellenschaltung SQ und der Verstärkerelektronik einschließlich der Schalter-Kondensator-Schaltung auf einem einzigen Halbleitersubstrat. Durch die monolithische Integration auf einem Halbleitersubstrat kann die erfindungsgemäße Leitfähigkeitsmeßvorrichtung stark miniaturisiert werden, so daß Messungen in kleinen Probenvolumina oder an sonst schwer zugänglichen Stellen, wie beispielsweise im Bereich der invasiven medizinischen Diagnostik, möglich sind.

Die Schaltungsbestandteile können in CMOS-Technologie ausgeführt werden. In diesem Fall kann die Herstellung der Elektroden kompatibel zum CMOS-Prozeß erfolgen, da lediglich der zusätzliche Verfahrensschritt des Aufbringens einer Edelmetallschicht für die Elektroden erforderlich ist.

Obwohl sich die erfindungsgemäße Leitfähigkeitsmeßschaltung vorzugsweise für eine vollständige Integration eignet, können auch Meßschaltungen mit getrennt angeordneten Elektroden nach dem erfindungsgemäßen Konzept realisiert werden.

## Patentansprüche

1. Integrierbare Leitfähigkeitsmeßvorrichtung zur Messung der elektrischen Leitfähigkeit von Flüssigkeiten,
mit einer Stromquellenvorrichtung (SQ), die an zwei Stromelektroden (E1,E4) derart angeschlossen ist, daß über die Stromelektroden (E1,E4) ein Strom mit einem rechteckförmigen Verlauf in die Flüssigkeit einspeisbar ist, und
mit einer an zwei Spannungselektroden (E2,E3) angeschlossenen Meßschaltung zum Bestimmen des Spannungsabfalles in der Flüssigkeit zwischen den Spannungselektroden, welcher von der elektrischen Leitfähigkeit der untersuchten Flüssigkeit abhängt,
dadurch gekennzeichnet,
daß die Meßschaltung eine Schalter-Kondensator-Schaltung ist, die einen Meßkondensator (C1), einen Differenzverstärker (OPV) mit einem in dessen Rückkopplungszweig angeordneten Rückkopplungskondensator (C2) und eine Schaltereinrichtung (S5 bis S11) aufweist, mittels der (S5 bis S11) die beiden Anschlüsse des Meßkondensators (C1) in zeitlicher Abhängigkeit von dem Verlauf des rechteckförmigen Stromes in einem Schaltzustand mit den Spannungselektroden (E2, E3) und in einem anderen Schaltzustand mit den beiden Eingängen des Differenzverstärkers (OPV) verbunden sind.

2. Integrierbare Leitfähigkeitsmeßvorrichtung nach Anspruch 1, dadurch gekennzeichnet,
daß die Stromquelleneinrichtung eine Gleichstromquelle (SQ) aufweist, die über einen ersten, zweiten, dritten und vierten Schalter (S1, S2, S3, S4) mit den Stromelektroden (E1, E4) in einer ersten und einer zweiten Polung verbunden ist.

3. Integrierbare Leitfähigkeitsmeßvorrichtung nach Anspruch 2, dadurch gekennzeichnet,
daß eine Steuervorrichtung vorgesehen ist, die den ersten, zweiten, dritten und vierten Schalter (S1, S2, S3, S4) derart ansteuert, daß sie die Stromquelle (SQ) alternierend während einer ersten Zeitdauer (T1) in der ersten Polung und während einer zweiten Zeitdauer (T2) in der zweiten Polung mit den Stromelektroden (E1, E4) verbinden.

4. Integrierbare Leitfähigkeitsmeßvorrichtung nach Anspruch 3, dadurch gekennzeichnet,
daß die Schaltereinrichtung einen fünften, sechsten, siebten und achten Schalter (S5, S6, S7, S8) aufweist,
daß die Steuervorrichtung den fünften bis achten Schalter (S5, S6, S7, S8) derart ansteuert, daß sie die Spannungselektroden (E2, E3) während einer dritten Zeitdauer (T3) in einer ersten Polung und während einer vierten Zeitdauer (T4) in einer zweiten Polung mit dem Meßkondensator (C1) verbinden, und
daß die dritte Zeitdauer (T3) innerhalb der ersten Zeitdauer (T1) und die vierte Zeitdauer (T4) innerhalb der zweiten Zeitdauer (T2) liegen.

5. Integrierbare Leitfähigkeitsmeßvorrichtung nach Anspruch 3, dadurch gekennzeichnet,
daß die erste und zweite Zeitdauer (T1, T2) gleich lang sind, so daß der reckteckförmige Strom im zeitlichen Mittel keinen Gleichanteil aufweist.

6. Integrierbare Leitfähigkeitsmeßvorrichtung nach einem der Ansprüche 1 bis 5, dadurch gekennzeichnet,
daß die Schaltereinrichtung (S5 bis S11) einen neunten und zehnten Schalter (S9, S10) aufweist, und
daß der Differenzverstärker (OPV) mit dem Meßkondensator (C1) über den neunten und zehnten Schalter (S9, S10) verbindbar ist.

7. Integrierbare Leitfähigkeitsmeßvorrichtung nach Anspruch 6, dadurch gekennzeichnet,
daß die Steuervorrichtung den neunten und zehnten Schalter (S9, S10) derart ansteuert, daß sie den Differenzverstärker (OPV) während einer fünften Zeitdauer (T5), die außerhalb der dritten und vierten Zeitdauer (T3, T4) liegt, mit dem Meßkondensator (C1) verbinden.

8. Integrierbare Leitfähigkeitsmeßvorrichtung nach einem der Ansprüche 1 bis 7, dadurch gekennzeichnet,
daß ein elfter Schalter (S11) parallel zu dem Rückkopplungskondensator (C2) liegt, und
daß die Steuervorrichtung den elften Schalter (S11) derart ansteuert, daß der Rückkopplungskondensator (C2) nach jeder fünften Zeitdauer (T5) entladen wird.

9. Integrierbare Leitfähigkeitsmeßvorrichtung nach einem der Ansprüche 1 bis 7, dadurch gekennzeichnet,
daß ein elfter Schalter (S11) parallel zu dem Rückkopplungskondensator (C2) liegt, und
daß die Steuervorrichtung den elften Schalter (S11) derart ansteuert, daß der Rückkopplungskondensator (C2) nach jeweils einer Mehrzahl von Perioden (T1, T2) entladen wird.

## Claims

1. Integrable conductivity measuring device for measuring the electric conductivity of liquids, comprising
a current source device (SQ) connectable to two current electrodes (E1, E4) such that a current with a rectangular waveform can be fed over the two current electrodes (E1, E4) to the liquid, and
a measuring circuit connected to two voltage electrodes (E2, E3) for determining the voltage drop between the voltage electrodes which is dependent on the electric conductivity of the investigated liquid,
characterized in that
the measuring circuit is a switched capacitor circuit having a measuring capacitor (C1), an amplifying circuit (OPV) with a feedback capacitor (C2) arranged in the feedback branch thereof, and a switch means (S5 to S11) by means of which (S5 to S11) the measuring capacitor (C1) is connectable in time-dependency on the behaviour of the current having the rectangular waveform in one switching condition with the voltage electrodes (E2, E3) and in another switching condition with the inputs of the amplifying circuit (OPV).

2. Integrable conductivity measuring device according to claim 1, characterized in that
the current source device comprises a dc current source (SQ) which is connectable via first, second, third and fourth switches (S1, S2, S3, S4) with the current electrodes (E1, E4) in first and second polarities.

3. Integrable conductivity measuring device according to claim 2, characterized in that
a control device is provided, controlling the first, second, third and fourth switches (S1, S2, S3, S4) in such a way that they connect the current source (SQ) alternately during a first period of time (T1) in the first polarity and during a second period of time (T2) in the second polarity with the current electrodes (E1, E4).

4. Integrable conductivity measuring device according to claim 3, characterized in that
the switch means has fifth, sixth, seventh and eighth switches (S5, S6, S6, S7, S8) ,
the control device controls the fifth to eigth switches (S5,S6,S7,S8) in such a way that they connect the voltage electrodes (E2,E3) during a third period of time (T3) in a first polarity, and during a fourth period of time (T4) in a second polarity with the measuring capacitor (C1), and
the third period of time (T3) lies within the first period of time (T1) and the fourth period of time (T4) within the second period of time (T2).

5. Integrable conductivity measuring device according to claim 3, characterized in that
the first and the second periods of time (T1, T2) are of equal length so that the current having the rectangular waveform has no dc portion in the time average.

6. Integrable conductivity measuring device according to one of claims 1 to 5, characterized in that
the switch arrangement (S5 to S11) has ninth and tenth switches (S9, S10), and
the amplifying circuit (OPV) is connectable with the measuring capacitor (C1) via the ninth and tenth switches (S9, S10).

7. Integrable conductivity measuring device according to claim 6, characterized in that
the control device controls the ninth and tenth switches (S9, S10) in such a way that they connect the amplifying circuit (OPV) during a fifth period of time (T5), lying outside the third and the fourth period of time (T3,T4), with the measuring capacitor (C1).

8. Integrable conductivity measuring device according to one of the claims 1 to 7, characterized in that
there is an eleventh switch (S11) parallel to the feedback capacitor (C2), and
the control device controls the eleventh switch (S11) in such a way that the feedback capacitor (C2) is discharged after each fifth period of time (T5).

9. Integrable conductivity measuring device according to one of claims 1 to 7, characterized in that
an eleventh switch (S11) is parallel to the feedback capacitor (C2), and
the control device controls the eleventh switch (S11) in such a way that the feedback capacitor (C2) is discharged after a plurality of periods (T1, T2).

## Revendications

1. Dispositif de mesure de conductivité intégrable destiné à mesurer la conductivité électrique de liquides,
avec un dispositif de source de courant (SQ) raccordé à deux électrodes de courant (E1, E4) de telle manière qu'un courant à trajectoire rectangulaire peut être alimenté dans le liquide par les électrodes de courant (E1, E4), et
avec un circuit de mesure raccordé à deux électrodes de tension (E2, E3), destiné à déterminer la chute de tension dans le liquide entre les électrodes de tension, laquelle est fonction de la conductivité électrique du liquide examiné,
caractérisé en ce que le circuit de mesure est un circuit commutateur-condensateur présentant un condensateur de mesure (C1), un amplificateur différentiel (OPV) avec un condensateur de réaction (C2) disposé dans son branchement de réaction, et un dispositif de commutation (S5 à S11) à l'aide duquel (S5 à S11) les deux connexions du condensateur de mesure (C1) sont raccordées, en fonction temporelle de l'évolution du courant rectangulaire, dans un état de commutation, aux électrodes de tension (E2, E3) et, dans un autre état de commutation, aux deux entrées de l'amplificateur différentiel (OPV).

2. Dispositif de mesure de conductivité intégrable suivant la revendication 1, caractérisé en ce que le dispositif de source de courant présente une source de courant continu (SQ) qui est reliée, par un premier, un second, un troisième et un quatrième commutateur (S1, S2, S3, S4) aux électrodes de courant (E1, E4), selon une première et une seconde polarité.

3. Dispositif de mesure de conductivité intégrable suivant la revendication 2, caractérisé en ce qu'il est prévu un dispositif de commande qui commande le premier, le second, le troisième et le quatrième commutatur (S1, S2, S3, S4) de telle manière qu'ils relient la source de courant (SQ) aux électrodes de courant (E1, E4) alternativement pendant une première période (T1) selon une première polarité et pendant une seconde période (T2) selon la seconde polarité,

4. Dispositif de mesure de conductivité intégrable suivant la revendication 3, caractérisé en ce
que le dispositif de commutation présente un cinquième, un sixième, un septième et un huitième commutateur (S5, S6, S7, S8),
que le dispositif de commande commande les cinquième à huitième commutateurs (S5, S6, S7, S8) de telle manière qu'ils relient les électrodes de tension (E2, E3) au condensateur de mesure (C1), pendant une trosième période (T3) selon une première polarité et pendant une quatrième période (T4) selon une seconde polarité, et
que la troisième période (T3) se situe dans les limites de la première période (T1) et la quatrième période (T4) dans les limites de la seconde période (T2).

5. Dispositif de mesure de conductivité intégrable suivant la revendication 3, caractérisé en ce que les première et seconde périodes (T1, T2) sont de même durée, de sorte que le courant rectangulaire ne présente pas de fraction continue au centre temporel.

6. Dispositif de mesure de conductivité intégrable suivant l'une des revendications 1 à 5, caractérisé en ce
que le dispositif de commutation (S5 à S11) présente un neuvième et un dixième commutateur (S9, S10), et
que l'amplificateur différentiel (OPV) peut être relié au condensateur de meusre (C1) par l'intermédiaire des neuvième et dixième commutateurs (S9, S10).

7. Dispositif de mesure de conductivité intégrable suivant la revendication 6, caractérisé en ce que le dispositif de commande commande les neuvième et dixième commutateurs (S9, S10) de telle manière qu'ils relient l'amplificateur différentiel (OPV) au condensateur de meusre (C1) pendant une cinquième période (T5) qui se situe en-dehors des troisième et quatrième périodes (T3, T4).

8. Dispositif de mesure de conductivité intégrable suivant l'une des revendications 1 à 7, caractérisé en ce
qu'un onzième commutateur (S11) se situe en parallèle avec le condensateur de réaction (C2), et
que le dispositif de commande commande le commutateur (S11) de telle manière que le condensateur de réaction (C2) est déchargé après chaque cinquième période (T5).

9. Dispositif de mesure de conductivité intégrable suivant l'une des revendications 1 à 7, caractérisé en ce
qu'un onzième commutateur (S11) se situe en parallèle avec le condensateur de réaction (C2), et
que le dispositif de commande commande le commutateur (S11) de telle manière que le condensateur de réaction (C2) est déchargé après chaque fois une pluralité de périodes (T1, T2).
